(19) Europäisches Patentamt / European Patent Office / Office européen des brevets

(11) **EP 4 187 266 B1**

(12) **FASCICULE DE BREVET EUROPEEN**

(45) Date de publication et mention
de la délivrance du brevet:
**11.09.2024 Bulletin 2024/37**

(21) Numéro de dépôt: **22209916.0**

(22) Date de dépôt: **28.11.2022**

(51) Classification Internationale des Brevets (IPC):
**G01R 31/36** (2020.01)      **G01R 31/3842** (2019.01)
**G01R 31/396** (2019.01)

(52) Classification Coopérative des Brevets (CPC):
**G01R 31/3648; G01R 31/3842; G01R 31/396**

(54) **IDENTIFICATION D'ANOMALIE DANS UN SYSTÈME ÉLECTROCHIMIQUE**

ANOMALIEIDENTIFIZIERUNG IN EINEM ELEKTROCHEMISCHEN SYSTEM

IDENTIFYING AN ANOMALY IN AN ELECTROCHEMICAL SYSTEM

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **29.11.2021 FR 2112656**

(43) Date de publication de la demande:
**31.05.2023 Bulletin 2023/22**

(73) Titulaire: **Electricité de France
75008 Paris (FR)**

(72) Inventeur: **BRUN, Emeric
77210 AVON (FR)**

(74) Mandataire: **Plasseraud IP
104 Rue de Richelieu
CS92104
75080 Paris Cedex 02 (FR)**

(56) Documents cités:
**CN-A- 111 308 382      FR-A1- 2 990 516
FR-A1- 3 018 360**

**Description**

**Domaine technique**

La présente divulgation relève du domaine des dispositifs électrochimiques de stockage d'énergie, et plus particulièrement du diagnostic de batteries, ou accumulateurs.

**Technique antérieure**

Il est connu de surveiller le comportement et les performances des batteries au fil du temps par exemple en mesurant certaines propriétés d'une batterie pour en déduire son état. L'un des paramètres de performance d'un dispositif électrochimique est une variable appelée « état de santé », ou SOH pour « State Of Health ». Ce paramètre, sans unité et exprimé généralement en pourcentage, se définit comme le rapport de la capacité électrique réelle $C_{rea}$ de l'élément testé sur la capacité électrique nominale $C_{nom}$ (ou la capacité en début de vie) du même élément. L'équation ci-après représente ce paramètre :

[Math. 1]

$$SOH = \frac{C_{rea}}{C_{nom}} \times 100$$

Un autre paramètre utile à la qualification d'un état d'un dispositif électrochimique est « l'état de charge », ou SOC pour « State Of Charge ». Ce paramètre est aussi sans unité et exprimé généralement en pourcentage. Le SOC se définit comme le rapport de la charge réelle disponible Qt de l'élément testé sur la charge maximale $Q_{max,t}$ du même élément dans son état de santé actuel. L'équation ci-après représente ce paramètre :

[Math. 2]

$$SOC = \frac{Q_t}{Q_{max,t}} \times 100$$

Il est possible de simuler le fonctionnement de systèmes et éléments électrochimiques en construisant des modèles théoriques. Dans ce cas, la pertinence des résultats virtuels dépend de la qualité de la modélisation. Il est aussi possible de mesurer des propriétés d'un élément électrochimique (réel donc) relatives à son état de santé. Généralement, cela nécessite de lui imposer des sollicitations particulières (cycles de caractérisation). Cela nécessite des équipements de contrôle particuliers et du temps. Les méthodes connues tendent même à dégrader les éléments testés et leur état de santé que l'on souhaite justement évaluer. De manière générale, un élément électrochimique soumis à de tels essais n'est plus opérationnel le temps des essais. Autrement dit, cela est réalisé au cours d'une période de maintenance, ou du moins hors d'un état de fonctionnement normal.

Quelques méthodes peuvent être mises en oeuvre pendant une phase opérationnelle du dispositif mais seulement dans certaines conditions de fonctionnement, par exemple lorsque la charge et/ou la décharge est complète. D'autres impliquent que des opérateurs entrent des données autres que des données de mesure du dispositif.

En pratique, il existe des systèmes de supervision et de contrôle des systèmes électrochimiques, souvent appelés BMS pour « Battery Management System ». Un BMS reçoit en entrées des paramètres et mesures lors du fonctionnement nominal d'un système électrochimique et fournit en sortie des données de diagnostic, par exemple des signaux d'alerte, et quelques données de mesure à destination de niveaux de contrôle supérieurs, souvent appelées « plateforme de supervision ». Typiquement, un BMS est localement associé à un unique système électrochimique et les données de diagnostic issues de plusieurs BMS sont collectés à distance de manière centralisée sur la plateforme de supervision. Cela signifie que, en pratique, au niveau de la plateforme de supervision en aval des BMS, seule une partie des données est disponible, souvent avec retard (pas en temps réel), et non l'intégralité des mesures effectuées et traitées localement par chaque BMS. Par exemple, même si un BMS collecte des mesures à un niveau de détail élevé, distinctement pour chaque élément composant un système électrochimique, les données fournies en sortie du BMS concernent le système dans son ensemble plutôt que chaque élément considéré en tant que tel.

Le document FR 2 990 516 A1 concerne une méthode d'estimation de l'état de charge d'une batterie comportant plusieurs cellules en série, caractérisée par la détermination à un instant donné de la tension de cellule minimum et de la tension de cellule maximum parmi les tensions de cellule. Les états de charge correspondant aux tensions maximale et minimale des cellules sont calculés et ceux-ci sont ensuite utilisés pour fournir l'état de charge global de la batterie.

Il serait théoriquement possible de modifier les BMS existants pour implémenter de nouveaux procédés de diagnostic. Cependant, cela impliquerait un grand nombre d'interventions directement au niveau de chaque système électrochimique. Il serait théoriquement possible de centraliser à distance et en temps réel l'intégralité des données mesurées localement aux niveaux des systèmes électrochimiques pour implémenter de nouveaux procédés de diagnostic au niveau de la plateforme de supervision. Cependant, le volume de données à transmettre puis à traiter au niveau de la plateforme de supervision impliquerait un surdimensionnement des infrastructures existantes, notamment en termes de réseau et de ressources de calcul. Il existe donc un besoin en diagnostic plus précis que ceux existants et qui ne nécessiterait pas plus de données de mesure que celles disponibles en sortie des BMS existants. En outre, des diagnostics indépendants de ceux fournis par les BMS permettent d'apporter une complémentarité dans la gestion des systèmes.

**Résumé**

La présente divulgation vient améliorer la situation.

Il est proposé un procédé de diagnostic d'un système électrochimique réel, mis en oeuvre par des moyens informatiques, ledit système étant composé d'une pluralité d'éléments électrochimiques électriquement connectés en série. Le procédé comprend :

a. collecter, pour une pluralité d'instants, des données de mesures du système, lesdites données étant horodatées et incluant, pour chaque instant, au moins :

- une tension et un courant aux bornes du système,
- la tension maximale aux bornes d'un premier élément électrochimique parmi les tensions aux bornes de chacun des éléments électrochimiques, associée à un identifiant dudit premier élément électrochimique,
- la tension minimale aux bornes d'un deuxième élément électrochimique parmi les tensions aux bornes de chacun des éléments électrochimiques, associée à un identifiant dudit deuxième élément électrochimique,

b. déduire, à partir desdites données de mesures, pour chaque instant :

- un état de charge de référence du système,
- un premier écart d'état de charge du premier élément par rapport à l'état de charge de référence du système,
- un deuxième écart d'état de charge du deuxième élément par rapport à l'état de charge de référence du système,

de manière à obtenir, pour chaque instant, un jeu de données associé à un couple d'éléments d'intérêt formé par les premier et deuxième éléments,

c. grouper les jeux de données par plages de valeurs de l'état de charge de référence de chaque jeu de données, de manière à retenir un jeu de données représentatif par plages de valeurs de l'état de charge de référence,

d. attribuer à chaque paire de données constituées de l'identifiant de l'élément l'électrochimique et de l'écart d'état de charge correspondant :

- une absence de fonction de diagnostic,

ou

l'une au moins des fonctions de diagnostic suivantes :

- une fonction d'identification d'au moins un élément électrochimique présentant une différence de capacité résiduelle par rapport à une capacité résiduelle nominale des éléments électrochimiques du système dans la plage de valeur de l'état de charge de référence ;
- une fonction de quantification de ladite ou lesdites différences de capacité résiduelle ;
- une fonction de quantification du déséquilibre maximal entre les éléments chimiques du système.

Selon un autre aspect, il est proposé un programme informatique comportant des instructions pour la mise en oeuvre de tout ou partie d'un procédé tel que défini dans les présentes lorsque ce programme est exécuté par un processeur. Selon un autre aspect, il est proposé un support d'enregistrement non transitoire, lisible par un ordinateur, sur lequel est enregistré un tel programme.

Un tel procédé permet d'effectuer un diagnostic différencié et précis de deux phénomènes physiques nuisibles au bon fonctionnement des systèmes électrochimiques à partir de données de mesure usuelles. Un tel diagnostic permet de mettre en oeuvre des mesures correctives ciblées, de manière fiable, pour améliorer les performances ultérieures des systèmes, leur durabilité et la sécurité des équipements et opérateurs voisins. Par « diagnostic différencié », on entend ici qu'il devient possible de détecter et identifier distinctement les phénomènes l'un de l'autre et aussi qu'il est possible d'identifier la source d'une anomalie à l'échelle précise d'un ou plusieurs éléments constituant le système électrochimique plutôt qu'à l'échelle globale et imprécise du système dans son ensemble. Par « données de mesure usuelles », on entend ici des données qui sont classiquement disponibles en fonctionnement opérationnel (non seulement pendant des phases de diagnostic, de maintenance ou expérimentales), y compris en aval des BMS. Autrement dit, lesdites données de mesure peuvent être obtenues sans qu'il soit nécessaire d'imposer un régime de fonctionnement spécifique, ni d'ajouter des équipements de mesure supplémentaire aux systèmes opérationnels existants. Il s'agit par exemple du courant traversant le système et de tensions aux bornes des éléments du système.

Les caractéristiques exposées dans les paragraphes suivants peuvent, optionnellement, être mises en oeuvre, indépendamment les unes des autres ou en combinaison les unes avec les autres :

Le groupement des jeux de données comprend, pour chaque plage de valeurs d'état de charge, le calcul :

- d'une première valeur représentative des premiers écarts d'états de charge déduites des données de mesure, ladite première valeur représentative correspondant à une moyenne non pondérée, une moyenne pondéré ou des quantiles, tels qu'une médiane, des premiers écarts d'états de charge,
- d'une deuxième valeur représentative des deuxièmes écarts d'états de charge déduites des données de mesure, ladite deuxième valeur représentative correspondant à une moyenne non pondérée, une moyenne pondéré ou une médiane des deuxième écarts d'états de charge,

lesdites première et deuxièmes valeur représentative calculées pour chaque plage de valeurs d'état de charge étant celles retenues pour l'attribution de fonctions de diagnostic ou d'absence de fonction de diagnostic.

Le nombre d'occurrences des identifiant des éléments électrochimiques parmi les données de mesures collectées est un paramètre d'attribution des fonctions de diagnostique ou d'attribution d'absence de fonction de diagnostic.

Chaque paire de données constituées de l'identifiant de l'élément l'électrochimique et de l'écart d'état de charge correspondant peut en outre se voir attribuée la fonction suivante :

- une fonction d'identification des éléments impliquées dans le déséquilibre maximal entre les éléments chimiques du système.

Le procédé comprend en outre une étape de diagnostic :
e. générer l'un au moins des signaux d'anomalie suivant en fonction des paires de données constituée de l'identifiant de l'élément l'électrochimique et de l'écart d'état de charge correspondant :

- une identification d'au moins un élément électrochimique présentant une différence de capacité résiduelle par rapport à une capacité résiduelle nominale des éléments électrochimiques du système dans la plage de valeur de l'état de charge de référence ;
- une quantification de ladite ou lesdites différences de capacité résiduelle ;
- une quantification du déséquilibre maximal entre les éléments chimiques du système.

Le procédé comprend en outre une étape de déclenchement d'au moins une mesure corrective en réponse à l'un au moins desdits signaux d'anomalie.

Les paires de données constituées de l'identifiant de l'élément l'électrochimique et de l'écart d'état de charge correspondant auxquelles une fonction de quantification de ladite ou lesdites différences de capacité résiduelle est attribuée sont utilisées conjointement dans la construction d'un modèle de régression linéaire, puis une quantification d'une anomalie de capacité résiduelle est mise en oeuvre en fonction de la valeur de pente dudit modèle de régression linéaire.

Les paires de données constituées de l'identifiant de l'élément l'électrochimique et de l'écart d'état de charge correspondant auxquelles une fonction de quantification du déséquilibre maximal entre les éléments chimiques du système est attribuée sont utilisées conjointement pour calculer une moyenne, pondérée ou non, ou des quantiles, tels qu'une médiane, des valeurs des premiers et deuxièmes écarts d'états de charge.

Les jeux de données sont obtenus pour une pluralité d'instants répartis sur une pluralité de cycles de charge et/ou décharge, complets ou partiels, dudit système électrochimique.

**Brève description des dessins**

D'autres caractéristiques, détails et avantages apparaîtront à la lecture de la description détaillée ci-après, et à l'analyse des dessins annexés, sur lesquels :

**Fig. 1**

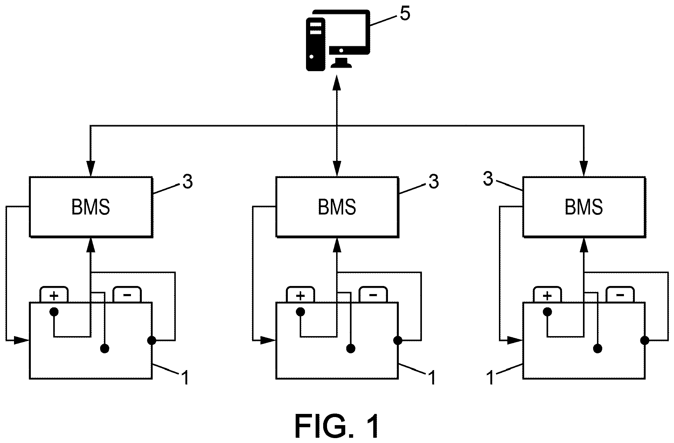

[Fig. 1] montre une architecture de gestion d'une pluralité de systèmes électrochimiques.

**Fig. 2**

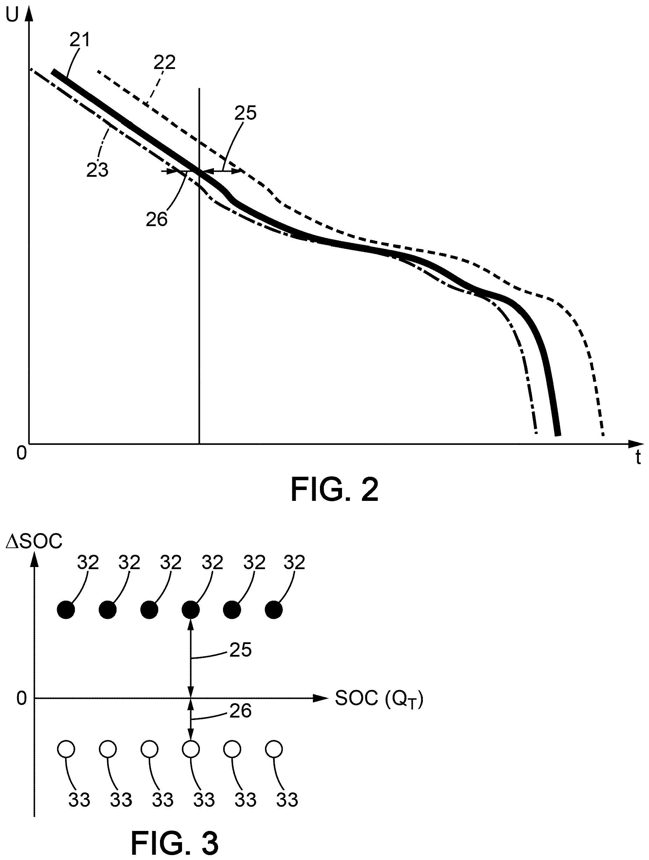

[Fig. 2] montre les tensions de plusieurs éléments d'un même système électrochimique au cours d'une décharge du système.

**Fig. 3**
[Fig. 3] montre les extremums de différence de SOC par rapport à la moyenne de SOC du système parmi les éléments du système de la figure précédente en fonction du SOC du système.

**Fig. 4**

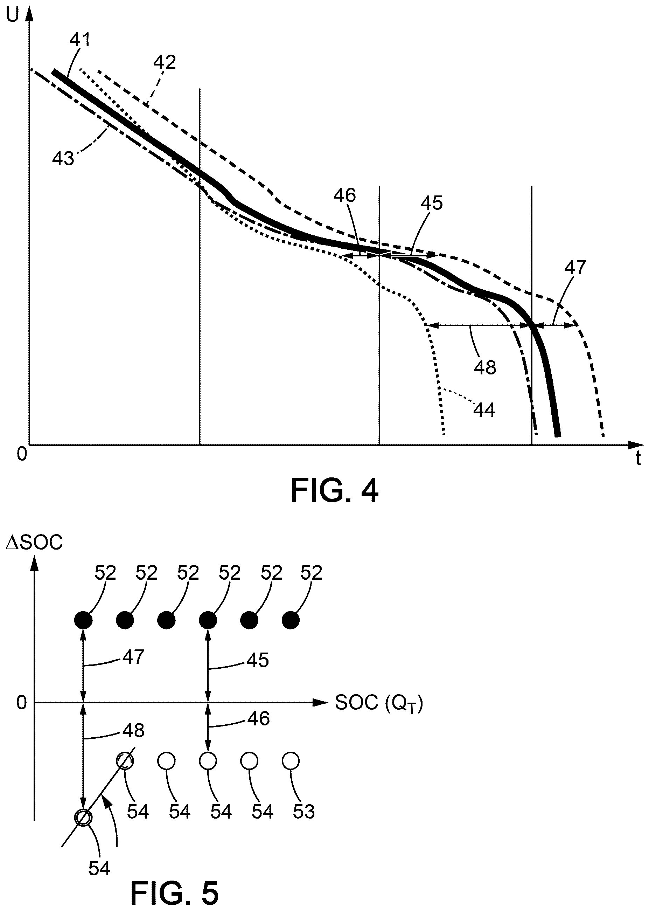

[Fig. 4] montre les tensions de plusieurs éléments d'un même système électrochimique au cours d'une décharge du système.

**Fig. 5**
[Fig. 5] montre les extremums de différence de SOC par rapport à la moyenne de SOC du système parmi les éléments du système de la figure précédente en fonction du SOC du système.

**Fig. 6**

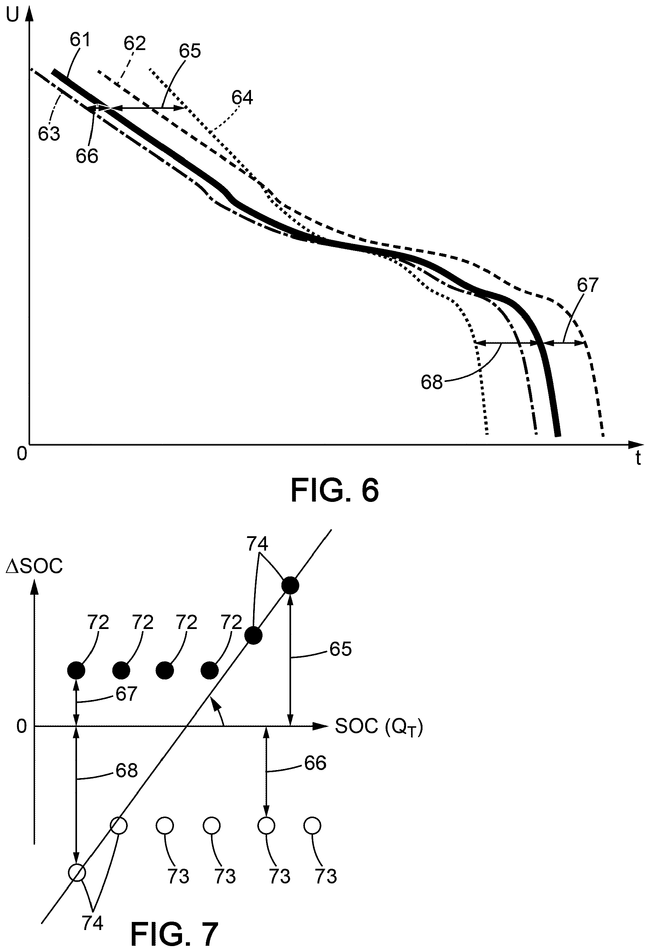

[Fig. 6] montre les tensions de plusieurs éléments d'un même système électrochimique au cours d'une décharge du système.

**Fig. 7**
[Fig. 7] montre les extremums de différence de SOC par rapport à la moyenne de SOC du système parmi les éléments du système de la figure précédente en fonction du SOC du système.

**Fig. 8**

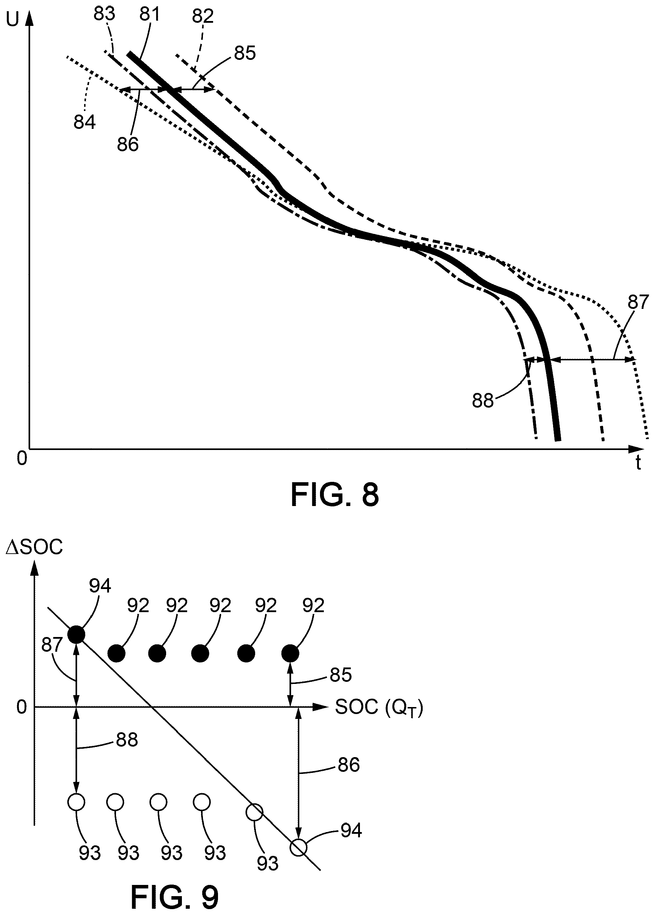

[Fig. 8] montre les tensions de plusieurs éléments d'un même système électrochimique au cours d'une décharge du système.

**Fig. 9**
[Fig. 9] montre les extremums de différence de SOC par rapport à la moyenne de SOC du système parmi les éléments du système de la figure précédente en fonction du SOC du système.

**Fig. 10**

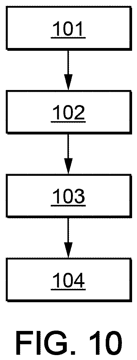

[Fig. 10] montre un diagramme de mise en oeuvre d'un procédé.

**Description des modes de réalisation**

Un système électrochimique se définit comme un ensemble composé d'une pluralité d'éléments électrochimiques électriquement connectés en série. De tels systèmes sont parfois appelés « rack » ou « string ». Chaque élément électrochimique, ou « cellule », peut être lui-même composé d'un ou plusieurs sous-éléments connectés les uns aux autres en série, en parallèle ou en combinaison de connexions série et parallèle. Ici, il est considéré que chaque élément chimique présente une tension unique à ses bornes à chaque instant.

Dans la suite, on distingue deux propriétés physiques au sein des systèmes électrochimiques : la capacité résiduelle de chaque élément et le déséquilibre entre les éléments en état de charge du système.

On souhaite idéalement quantifier et identifier les capacités résiduelles des éléments, c'est-à-dire attribuer une valeur de capacité résiduelle à chaque élément du système. Au cours de leur utilisation, les systèmes électrochimiques subissent des mécanismes de vieillissement qui se traduisent, au niveau macroscopique, par une baisse de leur capacité. Connectés en série, tous les éléments sont soumis au même courant de charge/décharge, hors courants d'équilibrage (décrits plus bas) et éventuelles autoconsommations du BMS (négligeables car inférieurs de plusieurs ordres de grandeurs au courant de charge/décharge). Un élément (ou cellule) ayant une capacité résiduelle plus faible que les autres éléments du système va donc se charger/décharger plus vite que les autres éléments. Dans un cas où le système est régulé par un seuil de tension nominal par élément (et en l'absence de courant d'équilibrage) l'élément le plus faible limite la performance du système dans son ensemble. Dans un cas où le système est régulé par un seuil de tension commun (par exemple une moyenne) pour tous les éléments (et en l'absence de courant d'équilibrage), l'élément le plus faible risque de fonctionner en dehors des plages de tension nominales, augmentant un risque de dysfonctionnement, de détérioration et donc de sécurité de l'assemblage. Cette capacité inférieure à la moyenne est irréversible : les éléments correspondants doivent être identifiés et leur état quantifié de manière à mettre en place les actions correctives adaptées.

On souhaite par ailleurs quantifier le déséquilibre maximal entre les éléments du système. En effet, tout système réel est imparfait et présente donc un déséquilibre. Bien que tous les éléments d'un assemblage série soient soumis au même courant, les différences dans les performances des éléments (taux d'autodécharge, rendement coulombique) ainsi que des courants prélevés localement comme ceux liés à l'équilibrage ou aux autoconsommations du BMS entrainent un désalignement progressif de l'état de charge des différents éléments. Pour les mêmes raisons que celles expliquées ci-dessus, un déséquilibre des éléments entraine une baisse de la performance de l'assemblage et/ou un risque vis-à-vis de sa sécurité. Ce déséquilibre d'état de charge est un phénomène réversible qui peut être corrigé par l'exécution d'une action d'équilibrage, par exemple en générant des courants d'équilibrage.

Il est maintenant fait référence à la figure 1. La figure 1 représente une architecture de gestion d'une pluralité de systèmes électrochimiques dans laquelle trois systèmes électrochimiques 1 sont chacun surveillés et contrôlés par un dispositif de gestion, ou PMS 3. Les PMS 3 sont reliés, ici à distance, à une plateforme de gestion centralisée 5 commune. La plateforme de gestion centralisée 5 reçoit des données de mesure et de diagnostic depuis chacun des PMS 3 et transmet en retour des instructions de commande.

La plateforme de gestion centralisée 5 comprend au moins un processeur associé à une mémoire et agencé pour mettre en oeuvre un procédé de diagnostic tel que décrit ci-après. En variante, l'un au moins des PMS 3 peut être agencé pour mettre en oeuvre un procédé de diagnostic tel que décrit ci-après. Chaque PMS 3 et/ou la plateforme de gestion centralisée 5 comprend donc des moyens informatiques pour la mise en oeuvre d'un procédé de diagnostic. Chaque système électrochimique 1 est composé d'une pluralité d'éléments électrochimiques électriquement connectés en série.

Dans un procédé de diagnostic d'un système 1, représenté en figure 10, une opération 101 est mise en oeuvre. L'opération 101 comprend :

    a. collecter, pour une pluralité d'instants t, des données de mesures du système 1, lesdites données étant horodatées et incluant, pour chaque instant t, au moins :

- une tension Ut et un courant It aux bornes du système 1,
- la tension maximale $U_{t,max}$ aux bornes d'un premier élément électrochimique $C_{t,1}$ parmi les tensions aux bornes de chacun des éléments électrochimiques, associée à un identifiant dudit premier élément électrochimique $C_{t,1}$,
- la tension minimale $U_{t,min}$ aux bornes d'un deuxième élément électrochimique $C_{t,2}$ parmi les tensions aux bornes de chacun des éléments électrochimiques, associée à un identifiant dudit deuxième élément électrochimique $C_{t,2}$.

Dans l'exemple décrit ici, les données sont collectées par la plateforme de gestion centralisée 5 par l'intermédiaire du PMS 3 connecté au système 1. En variante, les données sont collectées directement au niveau du PMS 3 ou du système 1. Dans ces cas, des données supplémentaires peuvent être collectées, telles que l'état de charge moyen. Dans des modes de réalisation, les instants t auxquels les mesures sont effectuées sur le système sont répartis sur une pluralité de cycles de charge et/ou décharge, complets ou partiels, du système 1. Autrement dit, les données collectées peuvent ne pas correspondre à un seul et même cycle de charge/décharge. Ainsi, la quantité de données collectées peut être importante, y compris en cas d'anomalie ou d'aberration temporaire dans les mesures. En outre, en travaillant sur une pluralité de cycles et en effectuant ultérieurement des traitements des données (filtres, éliminations de données aberrantes, moyennes, etc.) il est aisé de limiter l'effet de biais dans les diagnostics effectués sur la base de telles données. La pertinence et la fiabilité des mesures sont améliorées. En variante, par exemple lorsque les phases de charge/décharge sont très étalées dans le temps et/ou que l'on souhaite obtenir des résultats de diagnostic très rapidement, les données collectées peuvent correspondre à un même cycle de charge/décharge, voire être collectées et traitées en temps réel, pendant le fonctionnement opérationnel du système.

Il est maintenant fait référence aux figures 2 à 9. Les figures 2 à 9 sont des représentations graphiques de données mesurées ou de données déduites de données mesurées sur des systèmes électrochimiques réels. Elles constituent un exemple de données qui peuvent être collectées au cours de l'opération 101. Bien entendu, dans la mise en oeuvre du procédé, la collection de données ne se limite aucunement à une quelconque forme ou représentation graphique. Aussi, les exemples de représentation desdites données par les graphiques des figures ne sauraient être compris comme limitants.

Les figures 2, 4, 6 et 8 représentent chacune l'évolution de la tension aux bornes d'éléments particuliers d'un système électrochimique ainsi que d'une tension de référence Ut au cours du temps t pendant une phase de décharge du système. Ainsi, l'évolution du temps t est contraire à celle de l'évolution du SOC du système (non linéairement ici). Bien entendu, si une phase de charge était représentée, l'évolution du temps t se ferait dans le même sens que l'évolution du SOC du système (non linéairement *a priori*). Dans les exemples représentés, on se limite volontairement à un unique cycle de décharge afin de ne pas surcharger le graphique. Comme expliqué ci-avant, l'ensemble des données collectées pourraient concerner des mesures effectuées sur un cycle de charge et un cycle de décharge, ou même sur plusieurs cycles par exemple, y compris des cycles partiels (charges ou décharges incomplètes).

Les figures 2 et 3 correspondent à un système électrochimique (une situation) dans lequel les éléments constituant le système présentent des SOH identiques les uns aux autres (ayant des capacités résiduelles identiques les unes aux autres) mais présentant un déséquilibre imparfait. Contrairement aux exemples suivants, le système ne comprend pas d'élément faible ou fort. Les figures 4 et 5 correspondent à un système électrochimique (une situation) dans lequel il existe un « élément faible », c'est-à dire une cellule présentant une capacité résiduelle sensiblement plus faible que les autres cellules du système. Il existe également un déséquilibre imparfait. Les figures 6 et 7 correspondent aussi à un système électrochimique (une situation) dans lequel il existe un « élément faible », c'est-à dire une cellule présentant une capacité résiduelle sensiblement plus faible que les autres cellules du système. Il existe également un déséquilibre imparfait. Les figures 8 et 9 correspondent à un système électrochimique (une situation) dans lequel il existe un « élément fort », c'est-à dire une cellule présentant une capacité résiduelle sensiblement plus élevée que les autres cellules du système. Il existe également un déséquilibre imparfait.

Respectivement sur les figures 2, 4, 6 et 8 :

- la courbe de tension de référence est référencée respectivement 21, 41, 61 ou 81 ;
- la courbe de tension d'un élément présentant une tension élevée à ses bornes par comparaison aux autres éléments du système, est référencée respectivement 22, 42, 62 ou 82 ;
- la courbe de tension d'un élément présentant une tension basse à ses bornes par comparaison aux autres éléments du système, est référencée respectivement 23, 43, 63 ou 83.

Sur les figures 4 et 6, la courbe de tension de l'élément faible est référencée respectivement 44 et 64. Sur la figures 8, la courbe de tension de l'élément fort est référencée 84.

Sur les figures 2, 4, 6 et 8, des doubles flèches référencées 25, 45, 47, 65, 67, 85 et 87 représentent graphiquement, pour un instant t donné (ou un SOC donné du système), un écart d'état de charge $\Delta Q_{t,max}$ de l'élément présentant le plus grand état de charge du système par rapport à l'état de charge de référence Qt du système. Des doubles flèches référencées 26, 46, 48, 66, 68, 86 et 88 représentent graphiquement, pour ces mêmes instants t donnés (ou SOC donnés du système), un écart d'état de charge $\Delta Q_{t,min}$ de l'élément présentant le plus petit état de charge du système par rapport à l'état de charge de référence Qt du système. Dans ces exemples, la tension de référence correspond à la tension Ut aux bornes du système dans son ensemble divisée par le nombre d'éléments composant le système. La tension de référence est donc une moyenne. En variante, la tension de référence peut être calculée différemment, notamment en fonction des valeurs disponibles pour la déduire et/ou par application de facteurs correctifs. La tension de référence peut par exemple prendre la forme de quantiles tels qu'une médiane, ou encore une moyenne pondérée ou une combinaison de telles fonctions.

Les figures 2, 4 6, et 8 représentent les évolutions de tensions aux bornes d'éléments particuliers comparées à l'évolution d'une tension de référence au cours d'une phase de décharge et pour des scénarios connus (absence ou existence d'un élément fort ou faible). On comprend donc que ces figures ont un but explicatif mais ne correspondent pas nécessairement aux données connus initialement dans une situation réelle : au contraire, l'absence ou l'existence et l'identification d'éléments forts et/ou faibles est justement l'un des buts des procédés de diagnostic décrits ici. De même, l'ensemble des tensions aux bornes de chacun des éléments au cours du temps peuvent ne pas toutes faire partie des données disponibles et collectées à l'étape 101. Dans les exemples qui suivent, seule la tension maximale $U_{t,max}$, respectivement minimale $U_{t,min}$, parmi les tensions aux bornes de chacun des éléments électrochimiques sont collectées et associées à un identifiant de chacun des deux éléments électrochimiques $C_{t,1}$ et $C_{t,2}$ concernés.

Dans un procédé de diagnostic d'un système 1, après l'opération 101, une opération 102 est mise en oeuvre. L'opération 102 comprend :
b. déduire, à partir d'une partie au moins des données de mesures collectées à l'étape 101, pour chaque instant t :

- un état de charge de référence Qt du système 1,
- un premier écart d'état de charge $\Delta Q_{t,max}$ du premier élément $C_{t,1}$ par rapport à l'état de charge de référence Qt du système 1,
- un deuxième écart d'état de charge $\Delta Q_{t,min}$ du deuxième élément $C_{t,2}$ par rapport à l'état de charge de référence Qt du système 1.

La déduction de ces données est faite de manière à obtenir, pour chaque instant t, un jeu de données Qt, $\Delta Q_{t,max}$, $\Delta Q_{t,min}$, $C_{t,1}$, $C_{t,2}$, associé à un couple d'éléments d'intérêt formé par les premier et deuxième éléments $C_{t,1}$, et $C_{t,2}$. Dans des variantes, le jeu de données obtenus peut comprendre, en outre, des données associées à un élément de référence du système.

Dans un procédé de diagnostic d'un système 1, après l'opération 102, une opération 103 est mise en oeuvre. L'opération 103 comprend :
c. grouper les jeux de données Qt, $\Delta Q_{t,max}$, $\Delta Q_{t,min}$, $C_{t,1}$, $C_{t,2}$, par plages de valeurs (T) de l'état de charge de référence (Qt) de chaque jeu de données, de manière à retenir un jeu de données représentatif (T, $\Delta Q_{T,max}$, $\Delta Q_{T,min}$, $C_{T,1}$, $C_{T,2}$,) par plages de valeurs (T) de l'état de charge de référence.

L'opération de groupement (ou d'agrégation) des données permet d'obtenir des informations sur les déséquilibres en état de charge/décharge, non plus seulement dans le plan absolu du temps, mais dans le plan de l'état de charge (SOC). Un tel regroupement permet de lisser et réduire les biais causés par une éventuelle hétérogénéité du nombre et de la qualité des données mesurées sur la plage complète d'état de charge du système. Par exemple, un système électrochimique réel en fonctionnement peut osciller (cycles de charge-décharge) souvent entre 20% et 100% d'état de charge (SOC) car, pour des raisons pratiques évidentes, on souhaite éviter que le système soit entièrement déchargé. Dans ce cas, le nombre de mesures disponibles et collectées pour un état de charge compris entre 0% et 20% et au-delà de 100% (au-delà de la valeur maximum théorique) est sensiblement plus faible que pour les plages 20%-40% ; 40%-60% ; 60%-80% et 80%-100%. Regrouper les données par état de charge du système permet ensuite d'homogénéiser l'influence des données, par exemple en filtrant certaines données et/ou en appliquant des pondérations dans le traitement ultérieur des données. Ainsi, « retenir » un jeu de données représentatif par plages de valeurs de l'état de charge de référence peut être mis en oeuvre de diverses manières. Sous une forme algébrique, une pluralité de jeu de données collectées pour une plage d'état de charge peut être par exemple convertie en une moyenne, une moyenne pondérée ou des quantiles tels qu'une médiane d'écart d'état de charge. Un filtre peut être appliqué pour exclure des valeurs au-delà de seuils absolus ou relatifs prédéfinis. Par seuil relatif, on entend ici un seuil qui dépend de la distribution des valeurs obtenues tel que 110 % de la moyenne ou la somme de la moyenne et d'un écart-type, ou encore d'une combinaison de telles valeurs. Une unique valeur collectée peut être retenue. Sous une forme géométrique, un nuage de point peut être converti en un point représentant le barycentre du nuage. De même, lorsque plusieurs identifiants sont obtenus pour une valeur de maximum ou de minimum d'écart d'état de charge, les identifiants peuvent être retenus ou non en fonction de leur fréquence d'apparition. Par exemple, seul l'identifiant présentant la plus grande occurrence peut être retenu, ou bien seuls les deux identifiants présentant les deux plus grandes occurrences peuvent être retenus, etc.

Pour simplifier la compréhension, on considère ensuite qu'une unique valeur de maximum d'écart d'état de charge et une unique valeur de minimum d'écart d'état de charge pour chaque plage d'état de charge est retenu pour la suite du procédé de diagnostic. En variante, une pluralité de données peut être retenue chaque fois et traitées distinctement ensuite. Notamment, plusieurs valeurs de minimum ou de maximum d'écart d'état de charge pour une plage d'état de charge peuvent se voir attribuer des fonctions différentes dans la suite du diagnostic, en particulier lorsque plusieurs identifiants sont retenus pour chaque maximum/minimum tel que décrit ci-avant.

Pour illustrer des exemples de données collectées lors de l'opération 101 et de données déduites lors de l'opération 102 puis groupées lors de l'opération 103, on fait maintenant référence aux figures 3, 5, 7 et 9.

Les figures 3, 5, 7 et 9 représentent chacune des écarts d'état de charge maximum $\Delta Q_{t,max}$ et minimum $\Delta Q_{t,min}$ par rapport à un état de charge de référence Qt en fonction de l'état de charge de référence du système. En d'autres termes, l'état de charge de référence Qt correspond à l'axe des abscisses (valeur d'écart nulle), l'axe des abscisses représentant l'état de charge du système (SOC). Sur les figures 3, 5, 7 et 9, sont reprises les références des figures 2, 4, 6 et 8 des doubles flèches :

- 25, 45, 47, 65, 67, 85 et 87 pour les écarts d'état de charge $\Delta Q_{t,max}$ des éléments présentant le plus grand état de charge du système par rapport à l'état de charge de référence Qt du système ;
- 26, 46, 48, 66, 68, 86 et 88 pour les écarts d'état de charge $\Delta Q_{t,min}$ des éléments présentant le plus petit état de charge du système par rapport à l'état de charge de référence Qt du système.

Dans l'exemple décrit ici, chacun des extrema est en outre associé (ou « taggué ») à un identifiant de l'élément électrochimique présentant l'écart d'état de charge relevé. Sur les figures 3, 5, 7 et 9, les références des courbes des figures 2, 4, 6 et 8 sont réutilisées pour désigner les points correspondants et peuvent donc être assimilés à des identifiants des éléments électrochimiques. En variante, lorsque les identifiants ne sont pas disponibles ou qu'identifier les éléments n'est pas souhaité, les identifiants peuvent être absents (par exemple si on souhaite seulement quantifier les capacités résiduelles extrêmes). Dans d'autres variantes, chacun des extrema est associé à la fréquence d'apparition des identifiants plutôt qu'aux identifiants eux-mêmes.

Dans un procédé de diagnostic d'un système 1, après l'opération 103, une opération 104 est mise en oeuvre.

L'opération 104 comprend :

> d. attribuer à chaque paire $C_{T,1}$, $\Delta Q_{T,max}$ et $C_{T,2}$, $\Delta Q_{T,min}$ de données constituée de l'identifiant de l'élément l'électrochimique $C_{t,1}$, $C_{t,2}$ et de l'écart d'état de charge correspondant $\Delta Q_{t,max}$ et $\Delta Q_{t,min}$ :
>
> - une absence de fonction de diagnostic,
>
> ou
>
> l'une au moins des fonctions de diagnostic suivantes :
>
> - une fonction d'identification d'au moins un élément électrochimique présentant une différence de capacité résiduelle par rapport à une capacité résiduelle nominale des éléments électrochimiques du système dans la plage de valeur T de l'état de charge de référence (ci-après « fonction identification élément faible/fort ») ;
> - une fonction de quantification de ladite ou lesdites différences de capacité résiduelle (ci-après « fonction quantification capacité résiduelle faible/forte ») ;
> - une fonction de quantification du déséquilibre maximal entre les éléments chimiques du système (ci-après « fonction quantification déséquilibre »).

Dans des variantes, une fonction supplémentaire peut être prévue : celle d'identification des éléments impliqués dans le déséquilibre maximal du système (ci-après « fonction identification déséquilibre »). Une telle fonction permet en outre de caractériser les limites de l'enveloppe des tensions des éléments.

La possibilité d'attribuer une absence de fonction est particulièrement pertinente dans les modes de réalisation pour lesquels une pluralité de valeurs a été retenue en tant que minimum ou maximum d'écart d'état de charge pour une plage d'état de charge. N'attribuer aucune fonction de diagnostic lors de l'opération 104 peut alors être une alternative au filtrage de données au cours de l'opération 103.

L'attribution d'une ou plusieurs fonctions à une donnée est effectuée en fonction de la pertinence de cette donnée pour détecter, identifier et/ou quantifier un type d'anomalie possible. Autrement dit, on effectue une distinction entre les valeurs pour séparer les symptômes d'un problème d'équilibrage de ceux d'un élément faible ou fort, ce qui va permettre ensuite de distinctement les quantifier. Une telle distinction, par l'attribution de fonction(s), est permise par la comparaison avec les autres valeurs/données, autrement dit par une approche relative. En effet, en considérant une donnée/valeur isolément des autres, il est impossible d'affirmer si elle résulte d'une anomalie de type déséquilibrage entre éléments ou de type existence d'un élément fort ou faible.

Les règles d'attributions de fonctions mises en oeuvre au cours de l'opération 104 peuvent varier entre divers modes de réalisation. Les règles suivantes sont données à titre d'exemple : elles peuvent être mises en oeuvre chacune seules ou en combinaison les unes avec les autres mais ne sauraient être interprétées comme limitatives.

Dans des modes de réalisation, les jeux de données présentant un écart d'état de charge $\Delta Q_{t,max}$ supérieur à une valeur limite $\Delta Q_{t,max.nom}$ se voient attribuer l'une au moins des fonctions « identification élément faible/fort » et « quantification capacité résiduelle faible/forte ».

Dans des modes de réalisation, les jeux de données présentant un écart d'état de charge $\Delta Q_{t,min}$ inférieur à une valeur limite $\Delta Q_{t,min.nom}$ se voient attribuer l'une au moins des fonctions « identification élément faible/fort » et « quantification capacité résiduelle faible/forte ».

Un critère d'occurrence des identifiants $C_{T,1}$ ; $C_{T,2}$ peut en outre être appliqué. Par exemple, seuls les jeux de données pour lesquels l'identifiant a l'occurrence la plus élevée sur tout ou partie de l'état de charge du système se voient attribuer l'une au moins des fonctions « identification élément faible/fort » et « quantification capacité résiduelle faible/forte ». En variante, seuls les jeux de données pour lesquels l'identifiant a l'occurrence la plus élevée (ou strictement supérieur à 1) parmi ceux présentant un écart d'état de charge $\Delta Q_{t,max}$ supérieur, respectivement $\Delta Q_{t,min}$ inférieur, à une valeur limite $\Delta Q_{t,max.nom}$, respectivement $\Delta Q_{t,min.nom}$, se voient attribuer l'une au moins des fonctions « identification élément faible/fort » et « quantification capacité résiduelle faible/forte ». Par « *l'une au moins* » des fonction précités, on entend ici que chaque paire peut se voir attribuer une unique fonction, ou bien plusieurs cumulativement. En outre, deux paires d'une même plage de valeurs (T) de l'état de charge de référence peuvent se voir attribuer chacune des fonctions différentes l'une de l'autre.

Dans des modes de réalisation, les jeux de données présentant un écart d'état de charge $\Delta Q_{t,max}$ inférieur à une valeur limite $\Delta Q_{t,max.nom}$ se voient attribuer la fonction « quantification déséquilibre ».

Dans des modes de réalisation, les jeux de données présentant un écart d'état de charge $\Delta Q_{t,min}$ supérieur à une valeur limite $\Delta Q_{t,min.nom}$ se voient attribuer la fonction « quantification déséquilibre ».

Les valeur limites précitées $\Delta Q_{t,max.nom}$ et/ou $\Delta Q_{t,min.nom}$ peuvent être prédéterminées, ou calculée en fonction des valeurs d'écart d'état de charge des jeux de données. Par exemple, les valeurs limites peuvent être des limites absolues ou relatives prédéfinies. Par limite relative, on entend ici une valeur limite qui dépend de la distribution des valeurs obtenues telle que 110 % de la moyenne ou la somme de la moyenne et d'un écart-type ou encore d'une combinaison de telles valeurs. Les valeurs limites $AQ_{t.max.nom}$ et/ou $\Delta Q_{t,min.nom}$ peuvent être :

- identiques pour attribuer les fonctions « identification élément faible/fort » et « quantification capacité résiduelle faible/forte » d'une part et « quantification déséquilibre » d'autre part, de sorte que chaque jeu de données se voit attribuer soit uniquement les fonctions « identification élément faible/fort » et « quantification capacité résiduelle faible/forte », soit uniquement la fonction « quantification déséquilibre », et optionnellement « fonction identification déséquilibre » ; ou bien

- différentes pour attribuer les fonctions « identification élément faible/fort » et « quantification capacité résiduelle faible/forte » d'une part et la fonction « quantification déséquilibre » d'autre part, de sorte que certains jeux de données se voient attribuer à la fois les fonctions « identification élément faible/fort » et « quantification capacité résiduelle faible/forte », et à la fois la fonction « quantification déséquilibre », ou bien aucune de ces fonctions.

Dans des modes de réalisation, l'étape 104 d'attributions de fonction constitue l'ultime étape du procédé de diagnostic. L'obtention de données ainsi affiliées à une fonction « identification élément faible/fort » et/ou « quantification capacité résiduelle faible/forte » suffit à en déduire que le système comprend au moins un élément présentant une anomalie du type capacité résiduelle forte ou faible. En outre, l'identifiant associé à ces données permet en outre d'identifier, dans le système, le ou les éléments sujets à une capacité résiduelle forte ou faible. Au contraire, l'absence de données affiliées à une fonction « identification élément faible/fort » ou « quantification capacité résiduelle faible/forte » à l'issue de l'opération 104 indique l'absence d'élément sujet à une capacité résiduelle forte ou faible, ce qui est un diagnostic en soit.

Dans des modes de réalisation, lorsqu'on obtient des données auxquelles sont associées les fonctions « identification élément faible/fort » et/ou « quantification capacité résiduelle faible/forte », une opération supplémentaire de quantification d'une anomalie de capacité résiduelle est mise en oeuvre. Par exemple, les paires $C_{T,1}$, $\Delta Q_{T,max}$ et $C_{T,2}$, $\Delta Q_{T,min}$ de données constituée de l'identifiant de l'élément l'électrochimique $C_{t,1}$, ou $C_{t,2}$ et de l'écart d'état de charge correspondant $\Delta Q_{t,max}$ ou $\Delta Q_{t,min}$ sont utilisées conjointement dans la construction d'un modèle de régression linéaire

(voir figures 5, 7 et 9). Une quantification d'une anomalie de capacité résiduelle est ensuite obtenue en fonction de la valeur de pente dudit modèle de régression linéaire. En variante, d'autres moyen qu'une régression linéaire peuvent être mis en oeuvre pour quantifier une capacité résiduelle (relative par rapport à un élément de référence). Pour les paires de données auxquelles est associée la fonction « identification élément faible/fort », l'identifiant présentant la plus forte occurrence (ou l'unique identifiant) pour chacun du maximum et du minimum d'état de charge peut être retenu en tant qu'identifiant de l'élément fort, respectivement de l'élément faible. En variante, la distribution des identifiants peut être utilisée pour identifier plus d'un élément fort ou plus d'un élément faible.

Dans des modes de réalisation, lorsqu'on obtient des données auxquelles sont associées la fonction « quantification déséquilibre », une opération supplémentaire de quantification dudit déséquilibre est mise en oeuvre. Par exemple, les valeurs d'écart d'état de charge $\Delta Q_{t,max}$ ou $\Delta Q_{t,min}$ sont utilisées pour calculer une moyenne, pondérée ou non, ou des quantiles tels qu'une médiane des valeurs des premiers et deuxièmes écarts de charge $\Delta Q_{t,max}$ et $\Delta Q_{t,min}$ respectivement. La distribution des données auxquelles sont associées les fonctions « quantification déséquilibre » ou « identification déséquilibre » peut optionnellement être utilisée pour quantifier la fiabilité (ou « robustesse ») de ladite identification/quantification.

Dans des modes de réalisation, le procédé de diagnostic peut comprendre, en outre et postérieurement aux opérations décrites ci-avant, une opération d'« alerte ». Par exemple :

e. générer l'un au moins des signaux d'anomalie suivant en fonction données obtenues :

- une identification d'au moins un élément électrochimique présentant une différence de capacité résiduelle par rapport à une capacité résiduelle nominale des éléments électrochimiques du système dans la plage de valeur de l'état de charge de référence ;
- une quantification de ladite ou lesdites différences de capacité résiduelle ;
- une quantification du déséquilibre maximal entre les éléments chimiques du système.

Dans les variantes dans lesquelles une fonction « identification déséquilibre » est prévu, l'au moins un signal d'anomalie peut inclure au moins une identification d'un élément impliqué dans le déséquilibre.

Autrement dit, le procédé de diagnostic peut prendre, en sortie, la forme d'un diagnostic destiné à des opérateurs chargés de surveiller et d'assurer la maintenance du système, y compris des opérateurs qui ne sont pas en mesure d'interpréter les données chiffrées elles-mêmes.

Optionnellement, le procédé de diagnostic peut prendre, en sortie, la forme d'un signal de déclenchement d'au moins une mesure corrective en réponse à l'un au moins des diagnostics précités. Dans ce cas, le procédé devient plus qu'un procédé de diagnostic mais plus généralement un procédé de maintenance de systèmes électrochimiques, en partie au moins automatisé. Par exemple, on peut prévoir un signal de rétroaction déclenchant l'isolement (électrique) d'un élément à l'origine d'une anomalie ou d'un sous-ensemble du système contenant un élément à l'origine d'une anomalie.

**Application industrielle**

Les présentes solutions techniques peuvent trouver à s'appliquer sur tous types de batteries ou accumulateurs et notamment aux batteries de type Li-ion stationnaires (pour les réseaux ou le résidentiel par exemple) ou embarquées (véhicules par exemple).

En conclusion, les modes de réalisation du procédé décrit ci-avant permettent de ne pas nécessiter de données de mesure propres à chacun des éléments composant un système, mais au contraire de nécessiter seulement des données de mesure plutôt usuelles, en particulier relatives aux valeurs extrêmes plutôt qu'à chaque valeur de chaque élément. Ainsi, et contrairement à de nombreuses méthodes existantes, il n'est pas nécessaire d'effectuer des calculs lourds et un diagnostic absolu pour chaque élément du système pour ensuite faire une comparaison des éléments entre eux. Le procédé décrit ici permet de quantifier une capacité résiduelle en termes relatifs (par rapport à une capacité résiduelle de référence), ce qui suffit dans la plupart des cas à identifier une anomalie.

En outre, selon les méthodes connues, l'identification (et non la quantification) d'un élément ayant une capacité résiduelle plus faible/forte que la moyenne consiste à faire une analyse de la fréquence d'apparition des identifiants correspondant aux éléments en tension minimale ou maximale au cours du temps. Cela implique le postulat sous-jacent que, sur une période donnée, l'élément le plus faible sera celui le plus souvent associé à la tension minimum ou maximum de l'assemblage. Or, selon cette approche le résultat est fonction du temps pendant lequel le système se trouve dans chaque état de charge. En effet, en pratique, la cellule associée à la tension minimale n'est pas forcément la même à mi-charge et à pleine charge par exemple. En conséquence, dans une approche basée sur la fréquence d'apparition, les zones d'état de charge où le système passe le plus de temps vont être surpondérées. Au contraire, le procédé proposé ici, en se basant sur une approche dans le plan de l'état de charge plutôt que strictement temporelle, permet une identification et quantification des capacités résiduelles faibles/fortes par tranche d'état de charge : cela est plus pertinent pour aborder un problème lié par nature à la capacité des éléments et donc à leur état de charge. En particulier, les biais de pondération générés par les approches temporelles usuelles sont ici supprimés.

Quant à la quantification du déséquilibre en état de charge, il s'agit d'un diagnostic assez rare dans l'art antérieur. En pratique, le circuit d'équilibrage (la plupart du temps un équilibrage passif par dissipation d'énergie dans des résistances) est simplement activé sur critère de seuil de tension. Dans ce cas, aucune quantification préalable du déséquilibre n'est effectuée. Une approche plus avancée repose sur l'exécution de l'équilibrage à la suite d'une quantification du besoin d'équilibrage de chaque cellule. Ainsi, une estimation de l'écart de SOC entre les éléments est effectuée pour chacune des cellules afin d'appliquer un équilibrage adapté à chacune. Une telle approche repose, par exemple, sur un calcul du SOC au niveau d'un élément (une cellule). Cette approche est impossible lorsque des données ne sont pas disponibles pour chaque élément.

En outre, les méthodes connues jusque maintenant se basent souvent sur un diagnostic ponctuel à un instant donné. Au contraire, le procédé proposé repose quant à lui sur une quantité de données limitées mais portant sur une durée (un historique), par exemple de plusieurs jours, ce qui permet de tirer profit d'une plus grande variété de situations réelles et d'états du système. Pour autant, le procédé proposé peut tout à fait être mis en oeuvre « en temps réel », par exemple sur une fenêtre glissante de temps se terminant à l'instant présent.

Enfin, les approches traditionnelles traitent les problématiques de déséquilibre et de capacité résiduelle plus faible de manière indépendante, ce qui peut porter à confusion. En effet, regardé à un instant donné, un écart de tension d'un élément par rapport à la moyenne peut tout aussi bien être expliqué par un élément faible que par un déséquilibre. Le procédé proposé, en étant global et en exploitant un historique de données large permet d'obtenir un diagnostic plus précis et de meilleure qualité.

La demanderesse a appliqué le procédé décrit sur un système « saint » d'une part (présentant seulement des déséquilibres) et sur un autre système défaillant (éléments faibles et déséquilibres). Le procédé a été appliqué lors de diverses périodes de temps et dans des états de fonctionnement des systèmes différents les uns des autres sans que cela ne nuise à la bonne répétabilité des résultats. L'analyse du système saint a permis la quantification des déséquilibres hauts et bas avec une répétabilité de l'estimation de l'ordre de $\pm$ 0,25% SOC (en termes absolus) sur des fenêtres temporelles indépendantes les unes des autres. L'analyse du système défaillant a permis la quantification des déséquilibres hauts et bas avec une répétabilité de l'estimation de l'ordre de $\pm$ 0,5% SOC (en termes absolus) ainsi qu'une quantification de la capacité résiduelle de l'élément faible avec une variabilité de l'ordre de $\pm$ 20% (en termes relatifs), ordre de grandeur suffisant pour la détection d'un élément faible.

La présente divulgation ne se limite pas aux exemples de procédés, programmes informatiques et support d'enregistrement non transitoire lisible par un ordinateur décrits ci-avant, seulement à titre d'exemple, mais elle englobe toutes les variantes que pourra envisager l'homme de l'art dans le cadre de la protection recherchée, telle que définie par les revendications.

**Liste des signes de référence**

- 1 : Système électrochimique
- 3 : PMS
- 5 : plateforme de gestion centralisée
- 21 : courbe de tension de référence
- 22 : courbe de tension d'un élément
- 23 : courbe de tension d'un élément
- 25 : écart d'état de charge $\Delta Q_{t,max}$
- 32 : identifiant d'élément
- 33 : identifiant d'élément
- 41 : courbe de tension de référence
- 42 : courbe de tension d'un élément
- 43 : courbe de tension d'un élément
- 44 : courbe de tension d'un élément faible
- 45 : écart d'état de charge $\Delta Q_{t,max}$
- 46 : écart d'état de charge $\Delta Q_{t,min}$
- 47 : écart d'état de charge $\Delta Q_{t,max}$
- 48 : écart d'état de charge $\Delta Q_{t,min}$
- 52 : identifiant d'élément
- 53 : identifiant d'élément
- 54 : identifiant d'élément
- 61 : courbe de tension de référence
- 62 : courbe de tension d'un élément
- 63 : courbe de tension d'un élément
- 64 : courbe de tension d'un élément faible
- 65 : écart d'état de charge $\Delta Q_{t,max}$
- 66 : écart d'état de charge $\Delta Q_{t,min}$
- 67 : écart d'état de charge $\Delta Q_{t,max}$
- 68 : écart d'état de charge $\Delta Q_{t,min}$
- 72 : identifiant d'élément
- 73 : identifiant d'élément
- 74 : identifiant d'élément
- 81 : courbe de tension de référence
- 82 : courbe de tension d'un élément
- 83 : courbe de tension d'un élément
- 84 : courbe de tension d'un élément fort
- 85 : écart d'état de charge $\Delta Q_{t,max}$
- 87 : écart d'état de charge $\Delta Q_{t,max}$
- 86 : écart d'état de charge $\Delta Q_{t,min}$
- 88 : écart d'état de charge $\Delta Q_{t,min}$
- 92 : identifiant d'élément
- 93 : identifiant d'élément
- 94 : identifiant d'élément
- 101 : opération de collecte
- 102 : opération de déduction
- 103 : opération de groupement
- 104 : opération d'attribution de fonction(s).

**Revendications**

1. Procédé de diagnostic d'un système électrochimique réel, mis en oeuvre par des moyens informatiques, ledit système étant composé d'une pluralité d'éléments électrochimiques électriquement connectés en série, le procédé comprenant :

   a. collecter (101), pour une pluralité d'instants (t), des données de mesures du système, lesdites données étant horodatées et incluant, pour chaque instant (t), au moins :

   - une tension ($U_t$) et un courant ($I_t$) aux bornes du système,
   - la tension maximale ($U_{t,max}$) aux bornes d'un premier élément électrochimique ($C_{t,1}$) parmi les tensions aux bornes de chacun des éléments électrochimiques, associée à un identifiant dudit premier élément électrochimique ($C_{t,1}$),
   - la tension minimale ($U_{t,min}$) aux bornes d'un deuxième élément électrochimique ($C_{t,2}$) parmi les tensions aux bornes de chacun des éléments électrochimiques, associée à un identifiant dudit deuxième élément électrochimique ($C_{t,2}$),

   b. déduire (102), à partir desdites données de mesures, pour chaque instant (t) :

   - un état de charge de référence ($Qt$) du système,
   - un premier écart d'état de charge ($\Delta Q_{t,max}$) du premier élément ($C_{t,1}$) par rapport à l'état de charge de référence ($Qt$) du système,
   - un deuxième écart d'état de charge ($\Delta Q_{t,min}$) du deuxième élément ($C_{t,2}$) par rapport à l'état de charge de référence ($Qt$) du système,

   de manière à obtenir, pour chaque instant (t), un jeu de données ($Qt$, $\Delta Q_{t,max}$, $\Delta Q_{t,min}$, $C_{t,1}$, $C_{t,2}$,) associé à un couple d'éléments d'intérêt formé par les premier et deuxième éléments ($C_{t,1}$, $C_{t,2}$),
   c. grouper (103) les jeux de données ($Qt$, $\Delta Q_{t,max}$, $\Delta Q_{t,min}$, $C_{t,1}$, $C_{t,2}$,) par plages de valeurs (T) de l'état de charge de référence ($Qt$) de chaque jeu de données, de manière à retenir un jeu de données représentatif (T, $\Delta Q_{T,max}$, $\Delta Q_{T,min}$, $C_{T,1}$, $C_{T,2}$,) par plages de valeurs (T) de l'état de charge de référence,
   d. attribuer (104) à chaque paire ($C_{T,1}$, $\Delta Q_{T,max}$ ; $C_{T,2}$, $\Delta Q_{T,min}$) de données constituées de l'identifiant de l'élément l'électrochimique ($C_{t,1}$, $C_{t,2}$) et de l'écart d'état de charge correspondant ($\Delta Q_{t,max}$, $\Delta Q_{t,min}$) :

   - une absence de fonction de diagnostic,

   ou

   l'une au moins des fonctions de diagnostic suivantes :

   - une fonction d'identification d'au moins un élément électrochimique présentant une différence de capacité résiduelle par rapport à une capacité résiduelle nominale des éléments électrochimiques du système dans la plage de valeur (T) de l'état de charge de référence ;
   - une fonction de quantification de ladite ou lesdites différences de capacité résiduelle ;
   - une fonction de quantification du déséquilibre maximal entre les éléments chimiques du système.

2. Procédé selon la revendication 1, dans lequel le groupement des jeux de données comprend, pour chaque plage de valeurs (T) d'état de charge, le calcul :

   - d'une première valeur représentative ($\Delta Q_{T,max}$) des premiers écarts d'états de charge ($\Delta Q_{t,max}$) déduites des données de mesure, ladite première valeur représentative correspondant à une moyenne non pondérée, une moyenne pondéré ou des quantiles, tels qu'une médiane, des premiers écarts d'états de charge ($\Delta Q_{t,max}$),
   - d'une deuxième valeur représentative ($\Delta Q_{T,min}$) des deuxièmes écarts d'états de charge ($\Delta Q_{t,min}$) déduites des données de mesure, ladite deuxième valeur représentative correspondant à une moyenne non pondérée, une moyenne pondéré ou une médiane des deuxième écarts d'états de charge ($\Delta Q_{t,min}$),

   lesdites première et deuxièmes valeur représentative ($\Delta Q_{T,max}$, $\Delta Q_{T,min}$) calculées pour chaque plage de valeurs (T) d'état de charge étant celles retenues pour l'attribution de fonctions de diagnostic ou d'absence de fonction de diagnostic.

3. Procédé selon l'une des revendications précédentes, dans lequel le nombre d'occurrences des identifiant ($C_{t,1}$, $C_{t,2}$,) des éléments électrochimiques parmi les données de mesures collectées est un paramètre d'attribution des fonctions de diagnostique ou d'attribution d'absence de fonction de diagnostic.

4. Procédé selon l'une des revendications précédentes, dans lequel chaque paire ($C_{T,1}$, $\Delta Q_{T,max}$ ; $C_{T,2}$, $\Delta Q_{T,min}$) de données constituées de l'identifiant de l'élément l'électrochimique ($C_{t,1}$, $C_{t,2}$) et de l'écart d'état de charge correspondant ($\Delta Q_{t,max}$, $\Delta Q_{t,min}$) peut en outre se voir attribuée la fonction suivante :

   - une fonction d'identification des éléments impliquées dans le déséquilibre maximal entre les éléments chimiques du système.

5. Procédé selon l'une des revendications précédentes comprenant en outre une étape de diagnostic :
   e. générer l'un au moins des signaux d'anomalie suivant en fonction des paires ($C_{T,1}$, $\Delta Q_{T,max}$ ; $C_{T,2}$, $\Delta Q_{T,min}$) de données constituée de l'identiant de l'élément l'électrochimique ($C_{t,1}$, $C_{t,2}$) et de l'écart d'état de charge correspondant ($\Delta Q_{t,max}$, $\Delta Q_{t,min}$) :

   - une identification d'au moins un élément électrochimique présentant une différence de capacité résiduelle par rapport à une capacité résiduelle nominale des éléments électrochimiques du système dans la plage de valeur (T) de l'état de charge de référence ;
   - une quantification de ladite ou lesdites différences de capacité résiduelle ;
   - une quantification du déséquilibre maximal entre les éléments chimiques du système.

6. Procédé selon la revendication 5 comprenant en outre une étape de déclenchement d'au moins une mesure corrective en réponse à l'un au moins desdits signaux d'anomalie.

7. Procédé selon l'une des revendications précédentes, dans lequel les paires ($C_{T,1}$, $\Delta Q_{T,max}$ ; $C_{T,2}$, $\Delta Q_{T,min}$) de données constituées de l'identifiant de l'élément l'électrochimique ($C_{t,1}$, $C_{t,2}$) et de l'écart d'état de charge correspondant ($\Delta Q_{t,max}$, $\Delta Q_{t,min}$) auxquelles une fonction de quantification de ladite ou lesdites différences de capacité résiduelle est attribuée sont utilisées conjointement dans la construction d'un modèle de régression linéaire, puis une quantification d'une anomalie de capacité résiduelle est mise en oeuvre en fonction de la valeur de pente dudit modèle de régression linéaire.

8. Procédé selon l'une des revendications précédentes, dans lequel les paires ($C_{T,1}$, $\Delta Q_{T,max}$ ; $C_{T,2}$, $\Delta Q_{T,min}$) de données constituées de l'identifiant de l'élément l'électrochimique ($C_{t,1}$, $C_{t,2}$) et de l'écart d'état de charge correspondant ($\Delta Q_{t,max}$, $\Delta Q_{t,min}$) auxquelles une fonction de quantification du déséquilibre maximal entre les éléments chimiques du système est attribuée sont utilisées conjointement pour calculer une moyenne, pondérée ou non, ou des quantiles, tels qu'une médiane, des valeurs des premiers et deuxièmes écarts d'états de charge ($\Delta Q_{t,max}$, $\Delta Q_{t,min}$).

9. Procédé selon l'une des revendications précédentes, dans lequel lesdits jeux de données sont obtenus pour une pluralité d'instants (t) répartis sur une pluralité de cycles de charge et/ou décharge, complets ou partiels, dudit système électrochimique.

10. Programme informatique comportant des instructions pour la mise en oeuvre du procédé selon l'une des revendications précédentes lorsque ce programme est exécuté par un processeur.

11. Support d'enregistrement non transitoire lisible par un ordinateur sur lequel est enregistré un programme pour la mise en oeuvre du procédé selon l'une des revendications 1 à 9 lorsque ce programme est exécuté par un processeur.

**Patentansprüche**

1. Diagnoseverfahren eines realen elektrochemischen Systems, das durch Computermittel implementiert wird, wobei das System aus einer Vielzahl von elektrochemischen Elementen besteht, die elektrisch in Reihe geschaltet sind, wobei das Verfahren umfasst:

   a. Sammeln (101), für eine Vielzahl von Zeitpunkten (t), von Messdaten des Systems, wobei die Daten mit einem Zeitstempel versehen sind und für jeden Zeitpunkt (t) wenigstens umfassen:

- eine Spannung ($U_t$) und einen Strom ($I_t$) an den Klemmen des Systems,
- die maximale Spannung ($U_{t,max}$) an den Klemmen eines ersten elektrochemischen Elements ($C_{t,1}$) unter den Spannungen an den Klemmen jedes der elektrochemischen Elemente, die mit einer Kennung des ersten elektrochemischen Elements ($C_{t,1}$) verknüpft ist,
- die minimale Spannung ($U_{t,min}$) an den Klemmen eines zweiten elektrochemischen Elements ($C_{t,2}$) unter den Spannungen an den Klemmen jedes der elektrochemischen Elemente, die mit einer Kennung des zweiten elektrochemischen Elements ($C_{t,2}$) verknüpft ist,

b. Ableiten (102), aus den Messdaten, für jeden Zeitpunkt (t):

- eines Referenzladezustands ($Q_t$) des Systems,
- einer ersten Ladezustandsabweichung ($\Delta Q_{t,max}$) des ersten Elements ($C_{t,1}$) im Vergleich zum Referenzladezustand ($Q_t$) des Systems,
- einer zweiten Ladezustandsabweichung ($\Delta Q_{t,min}$) des zweiten Elements ($C_{t,2}$) in Bezug auf den Referenzladezustand ($Q_t$) des Systems, so dass für jeden Zeitpunkt (t) ein Datensatz ($Qt, \Delta Q_{t,max}, \Delta Q_{t,min}, C_{t,1}, C_{t,2}$) erhalten wird, der einem Paar von untersuchten Elementen zugeordnet ist, das aus dem ersten und dem zweiten Element ($C_{t,1}, C_{t,2}$) gebildet wird,

c. Gruppieren (103) der Datensätze ($Qt, \Delta Q_{t,max}, \Delta Q_{t,min}, C_{t,1}, C_{t,2}$) nach Wertebereichen (T) des Referenzlastzustands ($Q_t$) jedes Datensatzes, um einen repräsentativen Datensatz ($T, \Delta Q_{T,max}, \Delta Q_{T,min}, C_{T,1}, C_{T,2}$) nach Wertebereichen (T) des Referenzlastzustands zu behalten,
d. Zuweisen (104) zu jedem Paar ($C_{T,1}, \Delta Q_{T,max}; C_{T,2}, \Delta Q_{T,min}$,) von Daten, die aus der Kennung des elektrochemischen Elements ($C_{t,1}, C_{t,2}$) und der entsprechenden Ladezustandsabweichung ($\Delta Qt,max, \Delta Qt,min$) bestehen:

- einer fehlenden Diagnosefunktion,

oder

wenigstens einer der folgenden Diagnosefunktionen:

- eine Funktion zur Identifizierung wenigstens eines elektrochemischen Elements, das eine Differenz der Restkapazität in Bezug auf eine nominale Restkapazität der elektrochemischen Elemente des Systems im Wertebereich (T) des Referenzladezustands aufweist;
- eine Funktion zur Quantifizierung der genannten Differenz(en) der Restkapazität ;
- eine Funktion zur Quantifizierung des maximalen Ungleichgewichts zwischen den chemischen Elementen des Systems.

2. Verfahren nach Anspruch 1, wobei die Gruppierung der Datensätze für jeden Bereich von Werten (T) des Ladezustands die folgende Berechnung umfasst:

- eines ersten repräsentativen Wertes ($\Delta Q_{T,max}$) der aus den Messdaten abgeleiteten ersten Ladezustandsabweichungen ($\Delta Q_{t,max}$) wobei der erste repräsentative Wert einem ungewichteten Mittelwert, einem gewichteten Mittelwert oder Quantilen, wie einem Median, der ersten Ladezustandsabweichungen ($\Delta Q_{t,max}$) entspricht,
- eines zweiten repräsentativen Wertes ($\Delta Q_{T,min}$) der aus den Messdaten abgeleiteten zweiten Ladezustandsabweichungen ($\Delta Q_{t,min}$), wobei der zweite repräsentative Wert einem ungewichteten Mittelwert, einem gewichteten Mittelwert oder einem Median der zweiten Ladezustandsabweichungen ($\Delta Q_{t,min}$) entspricht,

wobei der erste und der zweite repräsentative Wert ($\Delta Q_{T,max}, \Delta Q_{T,min}$), die für jeden Bereich von Ladezustandswerten (T) berechnet werden, diejenigen sind, die für die Zuweisung der Diagnosefunktionen oder des Fehlens einer Diagnosefunktion ausgewählt wurden.

3. Verfahren nach einem der vorhergehenden Ansprüche, wobei die Anzahl des Auftretens der Kennungen ($C_{t,1}, C_{t,2}$) der elektrochemischen Elemente unter den gesammelten Messdaten ein Parameter für die Zuweisung der Diagnosefunktionen oder für die Zuweisung des Fehlens einer Diagnosefunktion ist.

4. Verfahren nach einem der vorhergehenden Ansprüche, wobei jedem Paar ($C_{T,1}, \Delta Q_{T,max}; C_{T,2}, \Delta Q_{T,min}$,) von Daten, die aus der Kennung des elektrochemischen Elements ($C_{t,1}, C_{t,2}$) und der entsprechenden Ladezustandsabweichung ($\Delta Q_{t,max}, \Delta Q_{t,min}$) bestehen, zusätzlich die folgende Funktion zugewiesen werden kann:

- eine Funktion zur Identifizierung der Elemente, die an dem maximalen Ungleichgewicht zwischen den chemischen Elementen des Systems beteiligt sind.

**5.** Verfahren nach einem der vorhergehenden Ansprüche, welches ferner einen Diagnoseschritt umfasst:

e. Erzeugen wenigstens eines der folgenden Anomaliesignale in Abhängigkeit von den Paaren ($C_{T,1}$, $\Delta Q_{T,max}$; $C_{T,2}$, $\Delta Q_{T,min}$,) von Daten, die aus der Kennung des elektrochemischen Elements ($C_{t,1}$, $C_{t,2}$) und der entsprechenden Ladezustandsabweichung ($\Delta Q_{t,max}$, $\Delta Q_{t,min}$) bestehen:

- eine Identifizierung wenigstens eines elektrochemischen Elements, das eine Differenz in der Restkapazität im Vergleich zu einer nominalen Restkapazität der elektrochemischen Elemente des Systems im Wertebereich (T) des Referenzladezustands aufweist;
- eine Quantifizierung der genannten Restkapazitätsdifferenz(en) ;
- eine Quantifizierung des maximalen Ungleichgewichts zwischen den chemischen Elementen des Systems.

**6.** Verfahren nach Anspruch 5, welches ferner einen Schritt zum Auslösen von wenigstens einer Korrekturmaßnahme als Reaktion auf wenigstens eines der Anomaliesignale umfasst.

**7.** Verfahren nach einem der vorhergehenden Ansprüche, wobei die Paare ($C_{T,1}$, $\Delta Q_{T,max}$; $C_{T,2}$, $\Delta Q_{T,min}$) die aus der Kennung des elektrochemischen Elements ($C_{t,1}$, $C_{t,2}$) und der entsprechenden Ladezustandsabweichung ($\Delta Qt,max$, $\Delta Qt,min$) bestehen, denen eine Funktion zur Quantifizierung der einen oder mehreren Restkapazitätsdifferenzen zugeordnet ist, gemeinsam bei der Erstellung eines linearen Regressionsmodells verwendet werden, und dann eine Quantifizierung einer Restkapazitätsanomalie in Abhängigkeit von dem Steigungswert des linearen Regressionsmodells durchgeführt wird.

**8.** Verfahren nach einem der vorhergehenden Ansprüche, wobei die Paare ($C_{T,1}$, $\Delta Q_{T,max}$; $C_{T,2}$, $\Delta Q_{T,min}$), die aus der Kennung des elektrochemischen Elements ($C_{t,1}$, $C_{t,2}$) und der entsprechenden Ladezustandsabweichung ($\Delta Q_{t,max}$, $\Delta Q_{t,min}$) bestehen, denen eine Funktion zur Quantifizierung des maximalen Ungleichgewichts zwischen den chemischen Elementen des Systems zugeordnet ist, gemeinsam verwendet werden, um einen gewichteten oder ungewichteten Mittelwert oder Quantile, wie z. B. einen Median, der Werte der ersten und zweiten Ladezustandsabweichungen ($\Delta Q_{t,max}$, $\Delta Q_{t,min}$) zu berechnen.

**9.** Verfahren nach einem der vorhergehenden Ansprüche, wobei die Datensätze für eine Vielzahl von Zeitpunkten (t) erhalten werden, die über eine Vielzahl von vollständigen oder teilweisen Lade- und/oder Entladezyklen des elektrochemischen Systems verteilt sind.

**10.** Computerprogramm mit Anweisungen zur Durchführung des Verfahrens nach einem der vorhergehenden Ansprüche, wenn dieses Programm von einem Prozessor ausgeführt wird.

**11.** Computerlesbares, nicht vorübergehendes Aufzeichnungsmedium, auf dem ein Programm zur Durchführung des Verfahrens nach einem der Ansprüche 1 bis 9 aufgezeichnet ist, wenn dieses Programm von einem Prozessor ausgeführt wird.

**Claims**

**1.** Diagnostic method for diagnosing an actual electrochemical system, implemented by computer means, said system being composed of a plurality of electrochemical elements electrically connected in series, the method comprising:

a. collecting (101) measurement data from the system at a plurality of instants (t), said data being timestamped and including, for each instant (t), at least:

- a voltage ($Ut$) and a current ($I_t$) across the terminals of the system,
- the maximum voltage ($U_{t,max}$), across the terminals of a first electrochemical element ($C_{t,1}$), among the voltages across the terminals of each of the electrochemical elements, associated with an identifier of said first electrochemical element ($C_{t,1}$),
- the minimum voltage ($U_{t,min}$), across the terminals of a second electrochemical element ($C_{t,2}$), among the voltages across the terminals of each of the electrochemical elements, associated with an identifier of said second electrochemical element ($C_{t,2}$),

b. deducing (102), from said measurement data, for each instant (t):

- a reference state of charge (Qt) of the system,
- a first state of charge deviation ($\Delta Q_{t,max}$) of the first element ($C_{t,1}$) relative to the reference state of charge (Qt) of the system,
- a second state of charge deviation ($\Delta Q_{t,min}$) of the second element ($C_{t,2}$) relative to the reference state of charge (Qt) of the system,

so as to obtain, for each instant (t), a data set (Qt, $\Delta Q_{t,max}$, $\Delta Q_{t,min}$, $C_{t,1}$, $C_{t,2}$,) associated with a pair of elements of interest formed of the first and second elements ($C_{t,1}$, $C_{t,2}$),
c. grouping (103) the data sets (Qt, $\Delta Q_{t,max}$, $\Delta Q_{t,min}$, $C_{t,1}$, $C_{t,2}$,) by ranges of values (T) of the reference state of charge (Qt) of each data set, so as to retain a representative data set (T, $\Delta Q_{t,max}$, $\Delta Q_{t,min}$, $C_{t,1}$, $C_{t,2}$,) by ranges of values (T) of the reference state of charge,
d. assigning (104) to each data pair ($C_{t,1}$, $\Delta Q_{t,max}$; $C_{t,2}$, $\Delta Q_{t,min}$) composed of the identifier of the electrochemical element ($C_{t,1}$, $C_{t,2}$) and the corresponding state of charge deviation ($\Delta Q_{t,max}$, $\Delta Q_{t,min}$):

- no diagnostic function,

or

at least one of the following diagnostic functions:

- an identification function for identifying at least one electrochemical element having a difference in residual capacity compared to a rated residual capacity of the electrochemical elements of the system, that is within the range of values (T) of the reference state of charge;
- a quantification function for quantifying said difference(s) in residual capacity;
- a quantification function for quantifying the maximum imbalance between the chemical elements of the system.

2. Method according to claim 1, wherein the grouping of the data sets comprises calculating, for each range of values (T) of the state of charge:

- a first representative value ($\Delta Q_{T,max}$) of the first state of charge deviations ($\Delta Q_{T,max}$) deduced from the measurement data, said first representative value corresponding to an unweighted mean, a weighted mean, or quantiles, such as a median, of the first state of charge deviations ($\Delta Q_{T,max}$),
- a second representative value ($\Delta Q_{T,min}$) of the second state of charge deviations ($\Delta Q_{T,min}$) deduced from the measurement data, said second representative value corresponding to an unweighted mean, a weighted mean, or a median, of the second state of charge deviations ($\Delta Q_{T,min}$),

said first and second representative values ($\Delta Q_{T,max}$, $\Delta Q_{T,min}$) calculated for each range of values (T) of the state of charge being those retained for the assignment of diagnostic functions or of no diagnostic function.

3. Method according to one of the preceding claims, wherein the number of occurrences of the identifiers ($C_{t,1}$, $C_{t,2}$) of the electrochemical elements among the measurement data collected is a parameter in assigning diagnostic functions or in assigning no diagnostic function.

4. Method according to one of the preceding claims, wherein each data pair ($C_{T,1}$, $\Delta Q_{T,max}$; $C_{T,2}$, $\Delta Q_{T,min}$) composed of the identifier of the electrochemical element ($C_{t,1}$, $C_{t,2}$) and the corresponding state of charge deviation ($\Delta Q_{t,max}$, $\Delta Q_{t,min}$) may also be assigned the following function:

- an identification function for identifying the elements involved in the maximum imbalance between the chemical elements of the system.

5. Method according to one of the preceding claims, further comprising a diagnostic step:
e. generating at least one of the following anomaly signals on the basis of the data pairs ($C_{T,1}$, $\Delta Q_{T,max}$; $C_{T,2}$, $\Delta Q_{T,min}$) composed of the identifier of the electrochemical element ($C_{t,1}$, $C_{t,2}$) and the corresponding state of charge deviation ($\Delta Q_{t,max}$, $\Delta Q_{t,min}$):

- an identification of at least one electrochemical element having a difference in residual capacity compared to a rated residual capacity of the electrochemical elements of the system within the range of values (T) of the reference state of charge;
- a quantification of said difference(s) in residual capacity;
- a quantification of the maximum imbalance between the chemical elements of the system.

6. Method according to claim 5, further comprising a step of triggering at least one corrective measure in response to at least one of said anomaly signals.

7. Method according to one of the preceding claims, wherein the data pairs ($C_{T,1}$, $\Delta Q_{T,max}$ ; $C_{T,2}$, $\Delta Q_{T,min}$) composed of the identifier of the electrochemical element ($C_{t,1}$, $C_{t,2}$) and the corresponding state of charge deviation ($\Delta Q_{t,max}$, $\Delta Q_{t,min}$) to which a quantification function for quantifying said difference(s) in residual capacity is assigned, are used together in constructing a linear regression model, then
a quantification of a residual capacity anomaly is implemented as a function of the slope value of said linear regression model.

8. Method according to one of the preceding claims, wherein the data pairs ($C_{T,1}$, $\Delta Q_{T,max}$ ; $C_{T,2}$, $\Delta Q_{T,min}$) composed of the identifier of the electrochemical element ($C_{t,1}$, $C_{t,2}$) and the corresponding state of charge deviation ($\Delta Q_{t,max}$, $\Delta Q_{t,min}$) to which a quantification function for quantifying the maximum imbalance between the chemical elements of the system is assigned, are used together to calculate a mean, weighted or not, or quantiles, such as a median, of the values of the first and second state of charge deviations ($\Delta Q_{t,max}$, $\Delta Q_{t,min}$).

9. Method according to one of the preceding claims, wherein said data sets are obtained for a plurality of instants (t) distributed over a plurality of charge and/or discharge cycles, complete or partial, of said electrochemical system.

10. Computer program comprising instructions for implementing the method according to one of the preceding claims when this program is executed by a processor.

11. Non-transitory computer-readable storage medium on which is stored a program for implementing the method according to one of claims 1 to 9 when this program is executed by a processor.

FIG. 1

FIG. 2

FIG. 3

FIG. 4

FIG. 5

FIG. 6

FIG. 7

FIG. 8

FIG. 9

```
┌─────────────────┐
│       101       │
└─────────────────┘
         │
         ▼
┌─────────────────┐
│       102       │
└─────────────────┘
         │
         ▼
┌─────────────────┐
│       103       │
└─────────────────┘
         │
         ▼
┌─────────────────┐
│       104       │
└─────────────────┘
```

# FIG. 10

**RÉFÉRENCES CITÉES DANS LA DESCRIPTION**

**Documents brevets cités dans la description**

- FR 2990516 A1